# EUROPÄISCHE PATENTANMELDUNG

(11) **EP 1 990 830 A1**
(43) Veröffentlichungstag der Anmeldung: **12.11.2008**
(21) Anmeldenummer: 07007557.7
(22) Anmeldetag: 12.04.2007
(51) Int. Cl.: H01L 23/40

(54) **Halbleitermodul**

(71) Anmelder: SIEMENS AKTIENGESELLSCHAFT, 80333 München (DE)
(72) Erfinder: Meier, Markus, 92286 Rieden (DE)

(57) **Zusammenfassung**

Ein Halbleitermodul weist ein Gehäuse auf, enthaltend einen Leistungshalbleiter, einen an diesem anliegenden Kühler zum Abführen von Verlustwärme, und ein sich zwischen Gehäuse und Kühler abstützendes, an der dem Leistungshalbleiter abgewandten Seite des Kühlers angeordnetes, den Kühler gegen den Leistungshalbleiter vorspannendes Federelement.

## Beschreibung

In vielen Bereichen der Technik, z.B. der industriellen Automatisierungstechnik, werden heute Leistungshalbleiter eingesetzt. Um die entsprechenden Leistungshalbleiter bzw. die mit ihnen realisierten Schaltungen handhabbar zu machen, sind diese in der Regel in ein Gehäuse, z.B. aus Kunststoff integriert. Derartige Anordnungen werden als Halbleitermodule bezeichnet und sind z.B. Schaltschütze, Motorstarter oder ähnliches. Leistungshalbleiter verursachen im Betrieb Wärmeverluste, die zu dessen kontinuierlicher Aufheizung und - falls die entstehende Wärme nicht abgeführt wird - zu dessen Zerstörung führen können. Die Abführung der Verlustwärme erfolgt in der Regel bevorzugt über ein Luft- oder auch über ein Wasser-Kühlsystem, welches an den Leistungshalbleiter angekoppelt ist. Zur Wärmeableitung müssen entsprechende Kühlsysteme möglichst gut an den Leistungshalbleiter bzw. ein mit diesem wärmegekoppeltes Teil angedrückt werden. Eine derartige Stelle ist in der Regel die Trägerschicht, z.B. eine Leiterplatte aus Keramik (DCB - direct copper bonding).

Bei großen abzuführenden Wärmemengen, z.B. in Umrichtern, ist es bekannt, den Leistungshalbleiter und den Kühler miteinander zu verschrauben. Z.B. wird die in der Regel viereckige Leiterplatte mit einer Schraube an jeder Ecke auf einem Kühlkörper verschraubt. Hierbei kann durch ungleichmäßiges Anziehen der Schrauben eine Verkippung zwischen Kühler und Leistungshalbleiter erfolgen, was z.B. zum Bruch der Leiterplatte führen kann. Schrauben können außerdem vergessen werden oder falsch oder gar nicht angezogen werden. Eine Endkontrolle einer korrekt angezogenen Schraube bei der Fertigung eines Halbleitermoduls ist extrem aufwendig. Durch Setzen des Schraubenkopfes auf seiner Auflage, z.B. einem Kunststoffgehäuse eines Halbleitermoduls, kann über der Zeit ein Vorspannverlust auftreten und der Anpressdruck zwischen Kühler und Leiterplatte unzulässig niedrig werden. Zum Verschrauben von Kühler und Leistungshalbleiter ist außerdem ein Anbohren bzw. Gewindeschnitt in Kühler und Leiterplatte notwendig.

Für Halbleiter kleinerer Leistung, z.B. bei Mikroprozessoren in PCs, ist es auch bekannt, einen Kühler mittels Spannfedern auf den Halbleiter aufzuspannen. Bei der Montage können die entsprechenden Spannfedern vergessen werden. Zum Angriff der Spannfedern sind in der Regel sowohl am Kühler als auch am Halbleiter bzw. Halbleitermodul entsprechende Aufnahmen notwendig, an denen Spannklammern o.ä. Halt finden. Dies erfordert bei deren Herstellung einen zusätzlichen Fertigungsschritt.

Aufgabe der vorliegenden Erfindung ist es, ein Halbleitermodul mit einer verbesserten Anpressung von Kühler und Leistungshalbleiter anzugeben.

Die Aufgabe wird gelöst durch ein Halbleitermodul mit einem Gehäuse, wobei im Gehäuse ein Leistungshalbleiter und ein Kühler enthalten sind. Der Kühler liegt an einer mit dem Leistungshalbleiter wärmegekoppelten Kühlfläche an und dient zum Abführen von dessen Verlustwärme über die Kühlfläche. Die Kühlfläche kann natürlich auch der Leistungshalbleiter selbst sein; dies ist jedoch selten der Fall, da der Leistungshalbleiter - wie oben erläutert - in der Regel auf einer Tragstruktur, z.B. einer Leiterplatte angeordnet ist, die dann die Kühlfläche aufweist.

Erfindungsgemäß ist im Halbleitermodul ein Federelement vorgesehen, welches sich zwischen Gehäuse und Kühler abstützt, an der Seite des Kühlers angeordnet ist, die von der Kühlfläche abgewendet ist, und welches den Kühler gegen die Kühlfläche vorspannt.

Im erfindungsgemäßen Halbleitermodul ist also das Andrücken des Kühlers auf die Kühlfläche und damit das Leistungsteil bzw. den Leistungshalbleiter mittels eines Federelementes gelöst, welches sich neben dem Kühler nicht am Leistungshalbleiter, sondern am Gehäuse abstützt. Die Abstützung des Federelementes am Gehäuse oder am Kühler muss hierbei nicht ganzflächig sein. Der Kühler wird somit über das Gehäuse des Halbleitermoduls gegen die Kühlfläche gedrückt. Somit fängt das Gehäuse die Vorspannkraft zwischen Kühler und Leistungshalbleiter auf. Da das Federelement zwischen Kühler und Gehäuse sich in der Regel durch Klemmung abstützt, ist eine mechanisches Bearbeitung des Kühlers nicht erforderlich. Kühler werden in der Regel im Strangpressverfahren hergestellt und auf die entsprechende Länge abgesägt. Die dem Leistungshalbleiter abgewandte Seite des Kühlers ist in der Regel damit eben. Da sich das Federelement in der Regel an dieser ebenen Seite abstützt, ist dort keine weitere Bearbeitung erforderlich.

Der Montageprozess des Halbleitermoduls ist vereinfacht, da kein Schraubvorgang oder Verbinden mittels Federklammern erforderlich ist. Schrauben oder Federklammern können nicht vergessen werden.

Beim Zusammenbau des Halbleitermoduls wird das Federelement in der Regel in das Gehäuse eingelegt und dann zwischen Gehäuse und Kühler durch Zusammensetzen des restlichen Gehäuses verpresst bzw. eingespannt. Durch diese einfache Montage besteht ein geringes Fehlerrisiko. Durch die schnelle Montage und die Einsparung von Einzelteilen wie Schrauben oder Federklammern ergibt sich eine Kosteneinsparung. Der Zusammenbau eines Gehäuses mit eingelegtem Federelement kann in der Regel translatorisch erfolgen, so dass ein Verkippen zwischen Kühler und Leistungshalbleiter vermieden ist.

Die Teilezahl im Halbleitermodul wird reduziert, der oben genannte Vorspannverlust von Schrauben vermieden, insbesondere wenn das Federelement am Gehäuse oder Kühler großflächig anliegt. Eine einfache Qualitätskontrolle nach Montage des Halbleitermoduls ist möglich, da diese sich auf das Vorhandensein des Federelementes beschränkt, das, wenn es denn eingelegt, also vorhanden ist, bei geeigneter Ausgestaltung - z.B. platten- oder scheibenförmig - nicht falsch eingelegt sein kann.

Das Federelement kann hierbei in einer ersten Ausführungsform der Erfindung als separates Bauteil ausgebildet sein. Geeignete Federelemente können dann bevorratet oder ausgetauscht werden.

Das Federelement kann eine Feder, insbesondere eine Spiral- oder Plattfeder sein. Derartige Federelemente stehen als Massenprodukte kostengünstig zur Verfügung.

Das Federelement kann ein Elastomerelement sein. Durch entsprechende Auswahl und Gestaltung eines Elastomerteils können hohe Andruckkräfte, z.B. vergleichbar mit einer vierfachen Verschraubung erreicht werden. Durch die Elastizität des Elastomers können außerdem große Geometrietoleranzen des Halbleitermoduls bei dennoch ausreichendem Anpressdruck ausgeglichen werden.

Das Elastomerelement kann plattenförmig ausgestaltet sein. Dadurch liegt es besonders gut an Kühler oder Gehäuse an.

In einer zweiten alternativen Ausführungsform der Erfindung kann das Federelement auch integral mit dem Gehäuse ausgebildet sein. Das Federelement kann hierbei z.B. im Gehäuse durch Eingießen integriert sein, wenn dieses an sich ein vorgefertigtes separates Teil ist, wie z.B. eine Feder. Das Federelement kann aber auch direkt an das Gehäuse angeformt sein.

Das Federelement kann eine elastische Teilstruktur des Gehäuses sein. So können z.B. am Gehäuse zu dessen Innenseite, also zum Kühler hin weisende Noppen, Vorwölbungen bzw. Ausformungen vorhanden sein. Die Federeigenschaft des Federelementes bzw. der Andruck des Kühlers an die Kühlfläche kann dann durch die Elastizität des Gehäusematerials und die z.B. geometrische Gestaltung der entsprechenden Anformungen gegeben sein.

Das Gehäuse kann eine Rastvorrichtung zum Zusammenbau des Halbleitermoduls unter Vorspannung des Federelementes aufweisen. Das Federelement wird dann z.B. in das Gehäuse eingelegt, der Kühler darauf gesetzt und anschließend zum Zusammenbau des Halbleitermoduls das Leistungsmodul oder ein entsprechendes zweites Gehäuseteil auf das Gehäuse soweit aufgepresst, dass unter Komprimierung des Federelementes die entsprechende Vorspannung entsteht, wobei erst im vorgespannten Zustand die Rastvorrichtung einrastet.

Eine entsprechende Verrastung kann durch manuellen Zusammenbau des Gehäuses oder Verpressung mit einer Pressvorrichtung für höhere Anpressdrücke erreicht werden.

Die Rastvorrichtung kann auch in eine den Leistungshalbleiter tragende Teilstruktur bzw. ein Teil des Halbleitermoduls eingreifen. Eine derartige Teilstruktur ist z.B. ein vormontiertes Leistungsteil, das den Halbleiter, die Leiterplatte und ein Gehäuse(ober)teil umfasst. Die Rastvorrichtung kann auch in die Tragstruktur, z.B. Leiterplatte oder direkt in den Leistungshalbleiter eingreifen.

Das Gehäuse kann auch eine Verschraubung zum Zusammenbau des Halbleitermoduls unter Vorspannung des Federelements aufweisen. Die Verschraubung ersetzt oder ergänzt dann in gleicher Wirkungsweise die oben genannte Verrastung.

Für eine weitere Beschreibung der Erfindung wird auf die Ausführungsbeispiele der Zeichnungen verwiesen. Es zeigen, jeweils in einer schematischen Prinzipskizze:
- FIG 1: ein Halbleitermodul im Querschnitt mit Elastomerelement als Federelement,
- FIG 2: ein Halbleitermodul gemäß FIG 1 in einer alternativen Ausführungsform mit an das Gehäuse angeformter Andrückkontur,
- FIG 3: ein Kraft-Weg-Diagramm für das Elastomerelement aus FIG 1.

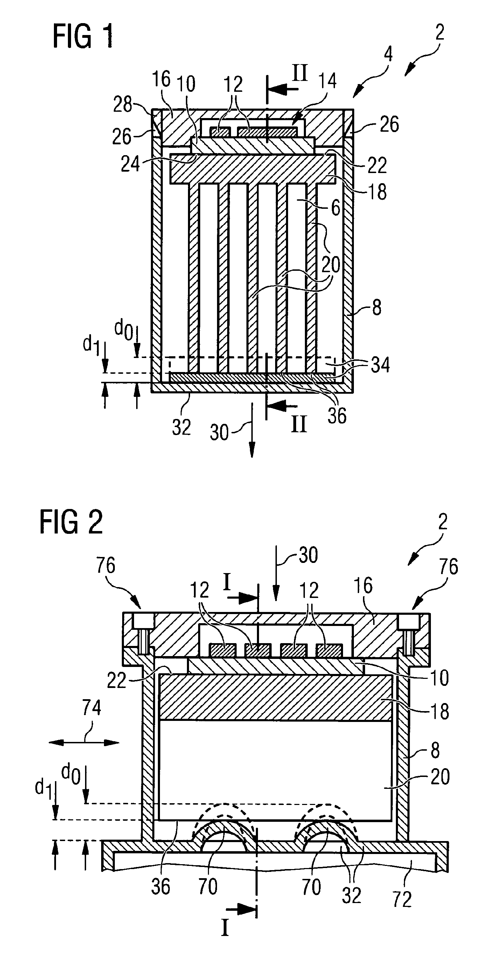

FIG 1 zeigt ein Halbleitermodul 2, umfassend ein Leistungsteil 4, einen Kühler 6 und ein Kühlergehäuse 8. Eine Leiterplatte 10 bildet zusammen mit darauf montierten Leistungshalbleitern 12 die eigentliche Leistungshalbleiter-Schaltung 14. Die Schaltung 14 ist mit einem Gehäuseoberteil 16 verbunden, im Beispiel über eine nicht dargestellte Verschnappung, um mit diesem zusammen das Leistungsteil 4 zu bilden.

Der Kühler 6 umfasst eine Kühlerplatte 18 und an dieser einstückig angeformte Rippen 20. Mit seiner Oberseite 22 liegt die Kühlerplatte 18 an der Unterseite 24 der Leiterplatte 10 an, die die Kühlfläche für die Leistungshalbleiter 12 darstellt. Zwischen beide ist nicht dargestellte Wärmeleitpaste eingebracht. Verlustwärme der Halbleiter 12 wird also über die Leiterplatte 10 zur Kühlerplatte 18 und zu den Kühlrippen 20 befördert, die von kühlender Luft durchströmt sind. Zwischen Kühler 6 und Kühlergehäuse 8 ist an dessen Boden 32 eine Elastomerplatte 34 verpresst.

Das Kühlergehäuse 8 hat im Wesentlichen die Form eines nach oben, also zum Leistungsteil 4 hin offenen Quaders, ist also im in FIG 1 gezeigten Querschnitt U-förmig. Das Kühlergehäuse 8 weist mehrere Ausnehmungen 26 auf, die zum Eingriff mit Rastnasen 28 dienen, welche wiederum am Gehäuseoberteil 16 angeformt sind.

In FIG 1 ist das Halbleitermodul 2 im fertig montierten Zustand gezeigt. Bei der Montage wird folgendermaßen vorgegangen: Zunächst wird in Richtung des Pfeils 30 in das noch leere Kühlergehäuse 8 auf die Innenseite des Bodens 32 eine Elastomerplatte 32 eingelegt. Anschließend wird der Kühler 6 mit den Kühlrippen 20 voraus, ebenfalls in Richtung des Pfeils 30 in das Kühlergehäuse 8 eingelegt. Anschließend wird die Oberseite 22 mit Wärmeleitpaste bestrichen und das vormontierte Gehäuseoberteil 16 mit der Unterseite 24 der Leiterplatte 10 voraus auf den Kühler 6 aufgesetzt. Die Elastomerplatte 34 ist noch unkomprimiert und besitzt die Dicke d₀. In der jetzigen Situation können die Rastnasen 28 noch nicht in Eingriff mit den Ausnehmungen 26 gebracht werden, da das Gehäuseoberteil 16 noch entgegen der Richtung des Pfeils 30 aus dem Kühlergehäuse 8 heraus ragt. Nun wird durch Aufbringen einer Kraft in Richtung des Pfeils 30 auf das Gehäuseoberteil 16 das Leistungsteil 4 zusammen mit dem Kühler 6 in Richtung des Bodens 32 gepresst und hierbei die Elastomerplatte 34 komprimiert, so dass deren Dicke vom Ausgangswert d₀ um einen Weg s=d₀-d₁ auf die komprimierte Dicke d₁ abnimmt . Nun rasten die Rastnasen 28 in die Ausnehmungen 26 ein.

Das Elastomerteil stützt sich nun zwischen Boden 32 und Kühlrippen 20 bzw. deren Unterseite 36 ab und erzeugt dort jeweils Andruckkräfte, die auch jeweils zwischen Kühler 6, Leiterplatte 10, Gehäuseoberteil 16 bzw. Rastnasen 28 und Kühlergehäuse 8 bzw. Ausnehmung 26 wirken. Hierdurch wird also insbesondere die Kühlerplatte 18 gegen die Leiterplatte 10 an der Kühlfläche vorgespannt.

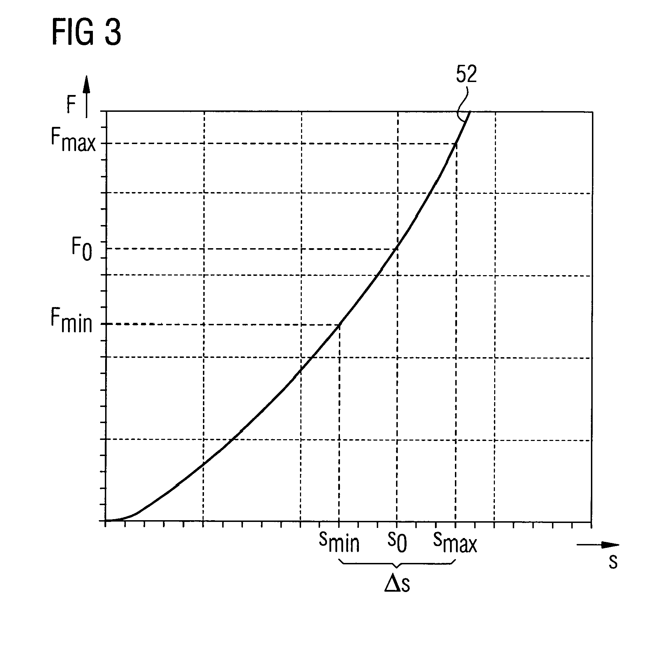

FIG 3 zeigt beispielhaft für die Elastomerplatte 34 eine Kurve 52 in einem Kraft-Weg-Diagramm. Auf der Abszisse ist der Kompressionsweg s, also die Differenz zwischen d₀ und d₁ aus FIG 1, und auf der Ordinate die von der Elastomerplatte 34 zurück gelieferte Kraft F angetragen.

Die geometrische Dimensionierung des Halbleitermoduls 2 ist derart ausgeführt, dass im fertig montierten Zustand gemäß FIG 1 die Elastomerplatte um s₀ bezüglich der Ausgangsdicke d₀ komprimiert ist. Hieraus ergibt sich eine Andruckkraft von F₀ zwischen der Kühlerplatte 18 und der Leiterplatte 10, was eine ausreichende Wärmeleitung sicherstellt. Die gesamten Bauteiltoleranzen im Halbleitermodul 2 sind derart ausgelegt, dass im einen Extremfall noch eine Kompression der Elastomerplatte 34, ausgehend von der Dicke d₀ um sₘᵢₙ erfolgt. Die minimale Andruckkraft ergibt sich aus FIG 3 daher zu Fₘᵢₙ. Bei der entgegengesetzten maximalen Toleranzlage ergibt sich eine Kompression der Elastomerplatte 34 von Sₘₐₓ was zu einer Andruckkraft von Fₘₐₓ führt. Durch die Elastomerplatte 34 können also Geometrietoleranzen Δs in einem weiten Bereich von Δs=sₘₐₓ-sₘᵢₙ ausgeglichen werden, ohne hierbei einen unzulässig niedrigen oder hohen Anpressdruck im Halbleitermodul 2 zu bewirken.

FIG 2 zeigt eine alternative Ausführungsform eines ansonsten zu FIG 1 baugleichen Halbleitermoduls 2. FIG 2 zeigt einen Schnitt entlang der Linie II-II aus FIG 1, wobei FIG 1 einem Schnitt entlang der Linie I-I durch FIG 2 zeigt. In FIG 2 ist daher auch die am Kühlergehäuse 8 angeformte Montagestruktur 72 zu sehen, welche zur Befestigung des Halbleitermoduls 2, z.B. in einem Schaltschrank, dient. Die Elastomerplatte 34 aus FIG 1 ist in FIG 2 ersetzt durch zum Inneren des Kühlergehäuses 8 hin gerichtete Verwölbungen 70 im Boden 32 des Kühlergehäuses 8. Die Vorwölbungen 70 sind hierbei durch Freischnitt und Verformung des Materials des Kühlergehäuses 8, z.B. Kunststoff, in dieses eingebracht und sind in Richtung des Pfeils 30 druckelastisch. Das erfindungsgemäße Federelement ist also hier integral mit dem Kühlergehäuse 8 ausgeführt.

Die Vorwölbungen 70 stützen sich jeweils an mehreren Stellen über der Länge einer Kühlrippe 20 ab. Durch entsprechende geometrische Ausgestaltung der Vorwölbungen 70 bzw. eine Materialauswahl des Kühlergehäuses 8 kann für diese eine Kraft-Weg-Kennlinie entsprechend der zur Kurve 52 aus FIG 3 realisiert werden. In FIG 2 ist auch zu erkennen, dass der Kühler 6 aus einem sich in Richtung des Pfeils 74 erstreckenden Strangpressprofil geschnitten ist. Die Oberseite 22 und Unterseite 36 sind daher in Richtung des Pfeils 74 bereits ab Herstellung eben.

In FIG 2 ist im Gegensatz zu FIG 1 außerdem die Verrastung aus Rastnasen 28 und Ausnehmungen 26 durch eine nicht näher erläuterte Verschraubung 76 ersetzt, welche das Gehäuseoberteil 16 gegen das Kühlergehäuse 8 in Richtung des Pfeils 30 niederdrückt und so die Vorwölbungen 70 auf die Dicke d₁ komprimiert.

## Patentansprüche

1. Halbleitermodul (2) mit einem Gehäuse (8,16), enthaltend einen Leistungshalbleiter (12), einen an einer mit dem Leistungshalbleiter (12) wärmegekoppelten Kühlfläche (24) anliegenden Kühler (6) zum Abführen von Verlustwärme, und ein sich zwischen Gehäuse (8,16) und Kühler (6) abstützendes, an der der Kühlfläche (24) abgewandten Seite (36) des Kühlers (6) angeordnetes, den Kühler (6) gegen die Kühlfläche (24) vorspannendes Federelement (34,70).

2. Halbleitermodul (2) nach Anspruch 1, mit einem zwischen Gehäuse (8,16) und Kühler (6) angeordneten, als separates Bauteil ausgebildeten Federelement (34,70).

3. Halbleitermodul (2) nach Anspruch 1 oder 2, bei dem das Federelement (34,70) eine Feder, insbesondere eine Spiral- oder Blattfeder, ist.

4. Halbleitermodul (2) nach Anspruch 1 oder 2, bei dem das Federelement (34,70) ein Elastomerelement (34) ist.

5. Halbleitermodul (2) nach Anspruch 4, bei dem das Elastomerelement (34) plattenförmig ist.

6. Halbleitermodul (2) nach einem der vorhergehenden Ansprüche, mit einem integral mit dem Gehäuse (8,16) ausgebildeten Federelement (34,70).

7. Halbleitermodul (2) nach Anspruch 6, bei dem das Federelement (34,70) eine elastische Teilstruktur (70) des Gehäuses (8,16) ist.

8. Halbleitermodul (2) nach Anspruch 7, bei dem das Federelement (34,70) eine zum Kühler (6) hin gerichtete Vorwölbung (70) des Gehäuses (8,16) ist.

9. Halbleitermodul (2) nach einem der vorhergehenden Ansprüche, bei dem das Gehäuse (8,16) eine Rastvorrichtung (26,28) zum Zusammenbau des Halbleitermoduls (2) unter Vorspannung des Federelements (34,70) aufweist.

10. Halbleitermodul (2) nach Anspruch 9, bei dem die Rastvorrichtung (26,28) an einer den Leistungshalbleiter (12) tragenden Teil (4) des Halbleitermoduls (2) eingreift.

11. Halbleitermodul (2) nach einem der vorhergehenden Ansprüche, bei dem das Gehäuse (8,16) eine Verschraubung (76) zum Zusammenbau des Halbleitermoduls (2) unter Vorspannung des Federelements (34,70) aufweist.

## Geänderte Patentansprüche

### Geänderte Patentansprüche gemäss Regel 137(2) EPÜ.

**1.** Halbleitermodul (2) mit einem Gehäuse (8,16), enthaltend einen Leistungshalbleiter (12), einen an einer mit dem Leistungshalbleiter (12) wärmegekoppelten Kühlfläche (24) anliegenden einstückigen Kühler (6) zum Abführen von Verlustwärme, und ein sich zwischen Gehäuse (8,16) und Kühler (6) abstützendes, an der der Kühlfläche (24) abgewandten Seite (36) des Kühlers (6) angeordnetes, den Kühler (6) gegen die Kühlfläche (24) vorspannendes Federelement (34,70).
